# EUROPEAN PATENT APPLICATION

(11) **EP 4 757 562 A1**
(43) Date of publication of application: **10.06.2026**
(21) Application number: 24383331.6
(22) Date of filing: 05.12.2024
(51) Int. Cl.: H10N 10/17, H10N 10/817, H10N 10/852

(54) **THERMOELECTRIC DEVICE**

(71) Applicant: Universitat Politècnica De Catalunya, 08034 Barcelona (ES)
(72) Inventor: PUIGDOLLERS GONZALEZ, Joaquim, 08440 Cardedeu (ES); SEGURA BLANCH, Oriol, 43520 Roquetes (ES); SAUCEDO SILVA, Edgardo Ademar, 08018 Barcelona (ES)
(74) Representative: Torner, Juncosa I Associats, SL

(57) **Abstract**

The present disclosure relates to a thermoelectric device comprising: a type n semiconductor and a type p semiconductor, the type n semiconductor and the type p semiconductor having two different contact portions, four conductive layers, and three metallic elements, wherein each of the two contact portions of the type n semiconductor are in contact with a first conductive layer and a second conductive layer, each of the two contact portions of the type p semiconductor are in contact with a third conductive layer and a fourth conductive layer, a first metallic element is in contact with the first conductive layer and the third conductive layer, the first conductive layer being in contact with the type n semiconductor, the third conductive layer being in contact with the type p semiconductor, a second metallic element is in contact with the second conductive layer, the second conductive layer being in contact with the type n semiconductor, and a third metallic element is in contact with the fourth conductive layer, the fourth conductive layer being in contact with the type p semiconductor.

## Description

### TECHNICAL FIELD

The present disclosure relates to a thermoelectric device.

### BACKGROUND ART

The objective of thermoelectric devices or, in general, thermoelectric systems or generators, is to generate a voltage (electrical potential difference) between two separate points (A and B) that have different temperatures, therefore providing energy from the temperature difference.

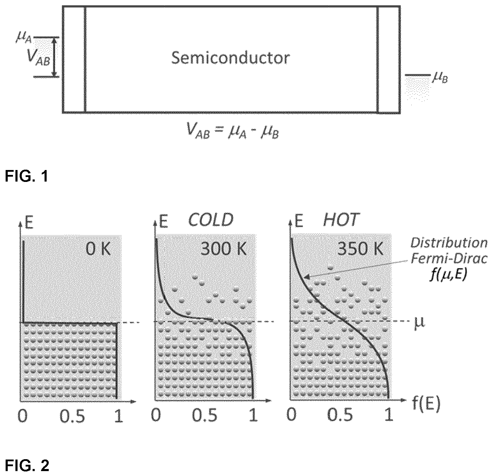

A thermoelectric system is basically composed of a semiconductor (n-type or p-type or combination of both) and two metals, one metal in contact with the cold point (A) and another metal in contact with the hot point (B). The voltage (V_{AB}) is generated between the cold spot (V_{A}) and the hot spot (V_{B}). These metals act as electrodes (FIG. 1).

The physical principle behind thermoelectricity is the diffusion of electric charge carriers from the hot spot to the cold spot. The electric charge carriers are electrons in an n-type semiconductor, and holes (absence of electrons) in a p-type semiconductor. In a semiconductor the number of electrons and holes is always the same, although not all electrons or holes participate equally in the electrical conductivity.

The energy distribution of electrons and holes in a metal depends on the metal and especially on the temperature of the metal. The higher the temperature, the greater the energy dispersion of electrons and holes. That is, at point B (higher temperature than at point A) more electrons (and holes) will be found with higher energy than at point A. The distribution of electrons (and holes) as a function of energy follows the Fermi-Dirac statistics (FIG. 2).

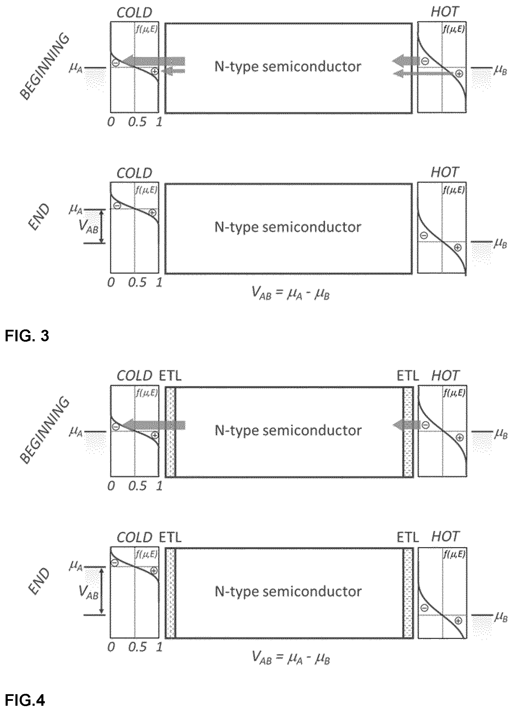

The diffusion of electrons from point B to point A, through the semiconductor, causes a higher presence of higher energy electrons at point B (cold) and a decrease of higher energy electrons at point A (hot). This increase in the average energy of the electrons at point B with respect to point A is the origin of the voltage that appears between A and B (V_{AB}) (FIG. 3). In FIG. 3 an n-type semiconductor is considered and the flow of carriers (electrons and holes) from the hottest to the coldest terminal is shown with arrows. Since it is an n-type semiconductor, the flow of electrons is higher than that of holes.

For the thermoelectric system to be efficient, the semiconductor (n-type, p-type or combination of both) must have high electrical conductivity of charge carriers (electrons, holes or electrons and holes) and low thermal conductivity. The high electrical conductivity is necessary for efficient diffusion of carriers from the hot spot to the cold spot, while the low thermal conductivity is necessary to avoid thermalization between the cold spot A and the hot spot B.

In the prior art, a number of proposals can be found in relation to thermoelectric devices and/or systems.

For instance, document US2003042497 relates to a thermoelectric element comprising at least one n-type layer and at least one p-type layer of one or more doped semiconductors, whereby the n-type layer(s) are arranged to form at least one pn-type junction. At least one n-type layer and at least one p-type are contacted in an electrically selective manner, and a temperature gradient is applied or tapped parallel (x-direction) to the boundary layer between at least one n-type layer and p-type layer. At least one pn-type junction is formed essentially along the entire, preferably longest, extension of the n-type layer(s) and of the p-type layer(s) and thus essentially along the entire boundary layer.

Document WO2009052920 relates to a thermoelectric generator having at least one first conductor layer made of thermoelectrically active material, a lateral temperature gradient parallel (in the x direction) to the surface of the thermoelectric material and at least two selective contacts for conducting the current produced by the generator. In order to create a thermoelectric generator having a greater degree of efficiency, thermal diffusion currents are influenced by an outside electrical and/or electromagnetic field. To this end, the thermoelectric generator comprises means for generating an electrical and/or electromagnetic field transverse to the current flow direction of the thermoelectric generator. With the aid of the field, the Seebeck coefficient may be changed, particularly increased. An increased Seebeck voltage will occur in the case of a subordinate, constant lateral temperature gradient between the two selective contacts for conducting the current produced by the generator if the specific resistance remains constant.

Document US2013312803 relates to an arrangement comprising a thermo-electric generator having a hot side which absorbs heat from a heat source, a cold side which discharges heat to a heat sink, and electrical terminals for outputting electrical energy with an output voltage and an electric circuit with a maximum permissible input voltage, the inputs of which are connected to the electrical terminals of the thermo-electric generator. Such arrangements may be used, for example, in exhaust systems of motor vehicles for more efficient use of the energy. In order to provide such an arrangement, which can be connected to a heat source, in particular an exhaust system of an internal combustion engine, largely independently of the magnitude of the temperature difference between the hot and cold sides of the thermo-electric generator, it is proposed that the thermo-electric generator be configured in such a way that saturation of the output voltage occurs below the maximum permissible input voltage of the electric circuit, or when said maximum permissible input voltage is reached.

However, there is a need in the art to develop thermoelectric systems and/or devices that may improve the system/device efficiency by increasing the output voltage. In fact, thermoelectric devices usually exhibit a lower open circuit voltage than the one expected for the selected working temperatures. This is due to the losses found between the metal-semiconductors interfaces. Moreover, due to poor band and energy level state alignment, some of the charge carriers of the metal contacts cannot get involved in the diffusion current that arise from the Seebeck effect. By increasing electron conduction at the required energy levels while blocking the undesired hole conduction states the output voltage of the device is improved, together with boosting the current generated by the n-type semiconductor. Similarly, by increasing hole conduction at the required energy levels while blocking the undesired electron conduction states, the output voltage of the device is improved together with boosting the current generated by the p-type semiconductor.

Therefore, there remains in the art the need to obtain thermoelectric devices having increased electron and hole conduction together with blocking undesired hole and electron conduction states.

### SUMMARY OF THE DISCLOSURE

A first aspect of the present disclosure relates to a thermoelectric device comprising: a type n semiconductor and a type p semiconductor, the type n semiconductor and the type p semiconductor having two different contact portions; four conductive layers; and three metallic elements; wherein each of the two contact portions of the type n semiconductor are in contact with a first conductive layer and a second conductive layer, each of the two contact portions of the type p semiconductor are in contact with a third conductive layer and a fourth conductive layer, a first metallic element is in contact with the first conductive layer and the third conductive layer, the first conductive layer being in contact with the type n semiconductor, the third conductive layer being in contact with the type p semiconductor, a second metallic element is in contact with the second conductive layer, the second conductive layer being in contact with the type n semiconductor, and a third metallic element is in contact with the fourth conductive layer, the fourth conductive layer being in contact with the type p semiconductor.

### BRIEF DESCRIPTION OF THE FIGURES

The foregoing and other advantages and features will be more fully understood from the following detailed description of an embodiment with reference to the accompanying drawings, to be taken in an illustrative and non-limitative manner, in which:
FIG. 1 illustrates the basic composition of a thermoelectric system, a semiconductor and two metals, one being in contact with the cold point and the other with the hot point.
FIG. 2 shows the distribution of electrons and holes as a function of energy, according to Fermi-Dirac statistics.
FIG. 3 shows a schematic representation of the diffusion of electrons from point B to point A, through a type n semiconductor.
FIG. 4 shows a schematic representation of the diffusion of electrons from point B to point A through a type n semiconductor when an electron transport layer is incorporated in both ends of the semiconductor.
FIG. 5 shows a schematic representation of the thermoelectric device according to the disclosure, combining a type n and type p semiconductor and incorporating selective contacts based on ETL and HTL.

### DESCRIPTION OF THE DISCLOSURE

The applicants would like to thank EU grant H2020-866018-SENSATE "Low dimensional semiconductors for optically tuneable solar harvesters".

The present disclosure, as defined herein, relates to a thermoelectric device comprising: a type n semiconductor and a type p semiconductor, the type n semiconductor and the type p semiconductor having two different contact portions; four conductive layers; and three metallic elements; wherein each of the two contact portions of the type n semiconductor are in contact with a first conductive layer and a second conductive layer, each of the two contact portions of the type p semiconductor are in contact with a third conductive layer and a fourth conductive layer, a first metallic element is in contact with the first conductive layer and the third conductive layer, the first conductive layer being in contact with the type n semiconductor, the third conductive layer being in contact with the type p semiconductor, a second metallic element is in contact with the second conductive layer, the second conductive layer being in contact with the type n semiconductor, and a third metallic element is in contact with the fourth conductive layer, the fourth conductive layer being in contact with the type p semiconductor.

A thermoelectric device, as understood herein and disclosed in the Background Art section, is a device that converts heat energy into electrical energy (or *vice versa*) through the thermoelectric effect. This effect relies on the relationship between temperature differences and electrical voltage in materials, typically made from semiconductors.

A semiconductor, according to the IUPAC, is a material whose conductivity, due to charges of both signs, is normally in the range between that of metals and insulators and in which the electric charge carrier density can be changed by external means.

The thermoelectric device as disclosed herein may have the two different contact portions of the type n semiconductor and the two different contact portions of the type p semiconductor opposed to each other, that is, each of the two contact portions of the type n semiconductor are opposed to each other and each of the two contact portions of the type n semiconductor are opposed to each other.

The thermoelectric device as disclosed herein preferably incorporates elements that act as electrical charge selectors between the semiconductor and the metal to improve system efficiency (higher output voltage).

The conductive layers of the thermoelectric device as disclosed herein may preferably be selective contact layers.

A selective contact, as understood herein, is a material that is able to separate energetically and spatially the charge carrier by reducing recombination rates of electrons, allowing that a greater part of the generated charge pairs to be consumed by an external circuit. Selective contacts have two functions: help the exit of a charge carrier type and block the way out of the other. Selective contacts are also known in the art as membranes, filters or transport layers. Normally selective contacts act as passivating layers such that they avoid the appearance of surface states and therefore avoid undesired Fermi level pining.

Selective contacts can be classified in electron transport layers (ETL) and hole transport layers (HTL).

Electron transport layers block the exit of holes from the semiconductor and help the way out for electrons.

Hole transport layers block the exit of electrons from the semiconductor and help the way out for holes.

The ETL will allow the passage of electrons and block the passage of holes. Depending on where the ETL is placed, cold spot or hot spot, the passage of electrons/blocking of holes will be from the semiconductor to the metal (cold spot) or from the metal to the semiconductor (hot spot). On the other hand, the HTL t will act in the opposite way, i.e., it will allow the passage of holes and block the passage of electrons.

ETL elements will be incorporated when the thermoelectric system is based on an n-type semiconductor. HTL elements will be incorporated when the thermoelectric system is based on a p-type semiconductor.

In the thermoelectric device as disclosed herein, the selective contact layers comprise an electron transport layer and/or a hole transport layer.

Preferably, the selective contact layers in contact with the two contact portions of the type p semiconductor are hole transport layers.

Preferably, the selective contact layers in contact with the two contact portions of the type n semiconductor are electron transport layers.

The incorporation of an ETL at one or both terminals in an n-type semiconductor will result in an increase in output voltage. The incorporation of an ETL, which blocks the passage of holes from the semiconductor to the metal (cold terminal) or from the metal to the semiconductor (hot terminal), reduces the probability, at the cold junction, of electrons in the metal recombining with holes in the metal, while the hot junction increases the probability of electrons being injected into the semiconductor from the metal. The result is an increase in the voltage provided by the device between the hot and cold terminals (FIG. 4).

The incorporation of an HTL at one or both terminals, in a p-type semiconductor will result in an increase in the output voltage. The incorporation of an HTL, which blocks the passage of electrons from the semiconductor to the metal (cold terminal) or from the metal to the semiconductor (hot terminal), reduces the probability, at the cold junction, of holes recombining with electrons, while at the hot junction it increases the probability of holes being injected into the semiconductor from the metal. The result is an increase in the voltage provided by the device between the hot and cold terminals (FIG. 4).

The selective contacts layers in ETL are made of materials preferably selected from the group consisting of thin layers of titanium oxide, zinc oxide, tin oxide, aluminum oxide and combinations thereof, and dipolar layers based on amine groups (R-NH2, where R is an alkyl group), including Polyethylenimine (PEI), Poly [(9,9-bis(3'-(N,N-dimethylamino)propyl)-2,7-fluorene)-alt-2,7-(9,9-dioctylfluorene)] (PFN), Polyethyleneoxide (PEO) polyethylenimine ethoxylated (PEIE), Polyamidoamine (PAMAM) dendrimers and combinations thereof.

Those layers might be deposited by several techniques, including atomic layer deposition (ALD), thermal evaporation, cathodic pulverization, spin-coating, inkjet-printing or dropcasting.

The selective contacts layers in HTL are made of materials preferably selected from the group consisting of thin layers of transition metal oxides (molybdenum oxide, vanadium oxide, tungsten oxide), Poly(3,4-ethylenedioxythiophene) polystyrene sulfonate (PEDOT-PSS), dipolar layers based on thiophene groups, carbazoles, phenothiazine, carboxylic acids, triphenyl amine, acridine and triazatruxene, PAMAM and combinations thereof.

Those layers might be deposited by several techniques, including atomic layer deposition (ALD), thermal evaporation, cathodic pulverization, spin-coating, inkjet-printing or dropcasting.

In the thermoelectric device as disclosed herein, the type n semiconductor and/or the type p semiconductor are made of calcohalides, antiperovskites, kesterites and/or combinations thereof.

Calcohalides refer to a class of compounds consisting of calcium (Ca) and halogens (such as chlorine, bromine or iodine). These materials typically have the general formula CaX2, where W represents the halogen element, and are often crystalline.

Antiperovskites are a family of materials with a crystal structure that is the inverse of the perovskite structure. In the perovskite structure, the general formula is ABX3, where "A" is a large cation (like a rare earth or alkali metal), "B" is a smaller metal cation (often a transition metal), and "X" is an anion, typically oxygen. In an anti perovskite, the positions of "A" and "B" are swapped, and the structure is typically represented as (A₃)BX. This results in a distinct crystal structure that can exhibit unique properties.

Kesterites are a class of compounds that refer to a family of oxide or sulfide materials with the general formula A₂BX₄, where A and B are cations (often alkali or alkaline earth metals), and X is an anion like oxygen or sulfur. The structure and bonding of kesterites may involve interesting interactions between these elements.

In another embodiment, the type n semiconductor as disclosed herein is made of antimony (III) selenoiodide (SbSel) and/or bismuth (III) selenoiodide (BiSel).

The first and second conductive layers in the thermoelectric device may be preferably made of a highly n-doped semiconductor, a low work function material or a dipolar material.

A highly n-doped semiconductor is understood herein as a semiconductor material that has been doped with a large number of donor impurities, which increase the concentration of free electrons in the material.

Examples of highly n-doped semiconductors are silicon doped with a significant concentration of phosphorus or arsenic atoms, gallium arsenide doped with sulfur, or organic n-type semiconductors such as Perylene diimide (PDI)-based polymers, Thieno-[3,4-c]pyrrole-4,6-dione (TPD)-based polymers, polymers based on Bithiophene imide (BTI) and derivatives, Lactam-based polymers, and combinations thereof.

A low work function material is understood herein as a material that requires relatively less energy to release an electron from its surface into the surrounding space (such as into a vacuum). The work function is the minimum energy needed to move an electron from the material's surface into the vacuum level (the energy level where the electron is free from the material's influence).

Examples of low work function materials are alkali metals, such as cesium, potassium or sodium; alkaline earth metals such as calcium, magnesium, barium; salts such as lithium fluoride, silver oxide, zinc oxide, tin oxide, titanium dioxide; carbon nanomaterials such as graphene or carbon nanotubes and rare earth metals such as lanthanum or thorium.

A dipolar material is a material that possesses a permanent dipole moment, that is, a separation of positive and negative charges within the material.

Examples of dipolar materials are lithium fluoride, magnesium oxide, and polymers comprising amino groups. Those polymers may be, for example, Poly [(9,9-bis(3'-(N,N-dimethylamino)propyl)-2,7-fluorene)-alt-2,7-(9,9-dioctylfluorene)] (PFN), polyethyleneimine (PEI), Polyethyleneoxide (PEO) and Polyamidoamine (PAMAM).

In particular, the highly n-doped semiconductor in the thermoelectric device according to this disclosure is selected from titanium dioxide, aluminum zinc oxide and/or combinations thereof, the low work function material is selected from calcium, magnesium, barium and/or combinations thereof, and the dipolar material is selected from lithium fluoride, magnesium oxide, polymers comprising amino groups and/or combinations thereof.

In the thermoelectric device according to the present disclosure, the type p semiconductor may be preferably made of antimony selenide (Sb₂Se₃), copper zinc tin sulfide (CZTS, Cu₂ZnSnS₄), copper zinc tin selenide (CZTSe, Cu₂ZnSnSe₄) and combinations thereof.

In the thermoelectric device as disclosed herein, the third and fourth conductive layers may be preferably made of a highly p-doped semiconductor, a high work function material or a dipolar material.

A highly p-doped semiconductor is understood herein as a semiconductor material that has been doped with a high concentration of acceptor atoms (dopants) to create an excess of holes (the absence of electrons, which act as positive charge carriers).

Examples of highly p-doped semiconductors are silicon doped with boron, aluminum or gallium, gallium arsenide doped with zinc, carbon or magnesium, germanium doped with boron or gallium, indium phosphide doped with zinc or carbon, copper indium gallium selenide doped with sodium, potassium or magnesium zinc oxide dope with copper or nitrogen, silicon carbide doped with boron and copper oxide or antimony tin dioxide. Other highly p-doped semiconductors might be organic materials such as polyacetylene (PA), polythiophenes (PTh), poly(3, 4-ethylenedioxythiophene)/polystyrene sulfonic acid (PEDOT-PSS), poly(3-methylthiophene) (P3MT), polyvinylidene fluoride (PVDF), poly(3-octylthiophene) (POT), poly(3-hexylthiophene) (P3HT), and combinations thereof.

A high work function material is understood herein as a material with a relatively large energy difference between its Fermi level (the highest energy of electrons at absolute zero) and the vacuum level (the energy required to remove an electron from the material into a vacuum). In high work function materials it takes more energy to remove an electron from the material compared to materials with a low work function.

Examples of high work function materials often include noble metals like platinum, gold or palladium, and oxides such as molybdenum trioxide, vanadium oxide, tungsten oxide and organic compounds like PEDOT-PSS.

In particular, the highly p-doped semiconductor according to the disclosure is selected from copper oxide, antimony tin dioxide and/or combinations thereof, the high work function material is selected from molybdenum trioxide, vanadium oxide, tungsten oxide and/or combinations thereof, and the dipolar material is selected from carbazoles, polymers comprising sulfonate groups, polymers comprising amino groups such as poly(amidoamine), polyethyleneimine, ethoxylated polyethyleneimine and/or combinations thereof.

The semiconductor might be doped by incorporating the above-mentioned compounds and/or elements inside the semiconductor structure. The incorporation might be made by coevaporation, cathodic co-pulverization, mixture in solution, co-diffusion in low/high pressure ovens, multilayer deposit and/or temperature annealing.

In a preferred embodiment, the conductive layers of the thermoelectric device according to the present disclosure are made of a dipolar material.

### DETAILED DESCRIPTION OF A PARTICULAR EMBODIMENT

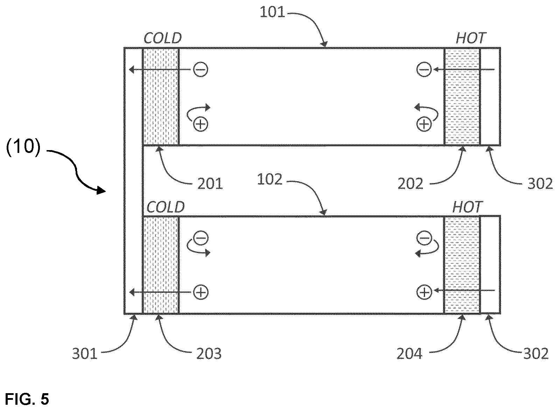

The thermoelectric device herein disclosed might be further understood by a detailed description of a particular embodiment, as shown in FIG. 5.

FIG. 5 shows a thermoelectric device (10) as described in the present disclosure. The thermoelectric device (10) comprises a type n semiconductor (101) and a type p semiconductor (102). Both the type n semiconductor (101) and the type p semiconductor (102) have at least two different contact portions.

The thermoelectric device (10) further comprises four conductive layers (201, 202, 203, 204) and three metallic elements (301, 302, 303).

In the thermoelectric device (10) each of the two contact portions of the type n semiconductor (101) are in contact with a first conductive layer (201) and a second conductive layer (202), while each of the two contact portions of the type p semiconductor (102) are in contact with a third conductive layer (203) and a fourth conductive layer (204).

A first metallic element (301) is in contact with the first conductive layer (201) and the third conductive layer (203), the first conductive layer (201) being in contact with the type n semiconductor (101) and the third conductive layer (203) being in contact with the type p semiconductor (102).

A second metallic element (302) is in contact with the second conductive layer (202), the second conductive layer (202) being in contact with the type n semiconductor (101).

A third metallic element (303) is in contact with the fourth conductive layer (204), the fourth conductive layer (204) being in contact with the type p semiconductor (102).

In the embodiment shown in FIG. 5, the two contact portions of the type n semiconductor (101) and the two contact portions of the type p semiconductor (102) are opposed to each other, and, therefore, the first and second conductive layer (201, 202) are opposed to each other and the third and fourth conductive layer (203, 204) are opposed to each other, respectively.

The first metallic element (301) allows the combination of both type n semiconductor (101) and type p semiconductor (102) in the same thermoelectric device (10).

## Claims

1. A thermoelectric device (10) comprising:
a type n semiconductor (101) and a type p semiconductor (102), the type n semiconductor (101) and the type p semiconductor (102) having two different contact portions
four conductive layers (201, 202, 203, 204), and
three metallic elements (301, 302, 303),
wherein
each of the two contact portions of the type n semiconductor (101) are in contact with a first conductive layer (201) and a second conductive layer (202),
each of the two contact portions of the type p semiconductor (102) are in contact with a third conductive layer (203) and a fourth conductive layer (204),
a first metallic element (301) is in contact with the first conductive layer (201) and the third conductive layer (203), the first conductive layer (201) being in contact with the type n semiconductor (101), the third conductive layer (203) being in contact with the type p semiconductor (102),
a second metallic element (302) is in contact with the second conductive layer (202), the second conductive layer (202) being in contact with the type n semiconductor (101), and
a third metallic element (303) is in contact with the fourth conductive layer (204), the fourth conductive layer (204) being in contact with the type p semiconductor (102).

2. The thermoelectric device according to claim 1, wherein the two different contact portions of the type n semiconductor (101) and the type p semiconductor (102) are opposed to each other.

3. The thermoelectric device according to claims 1 or 2, wherein the conductive layers (201, 202, 203, 204) are selective contacts layers.

4. The thermoelectric device according to claim 3, wherein the selective contact layers comprise an electron transport layer and/or a hole transport layer.

5. The thermoelectric device according to claim 4, wherein the selective contact layers in contact with the two contact portions of the type p semiconductor are hole transport layers.

6. The thermoelectric device according to claims 4 or 5, wherein the selective contact layer in contact with the two contact portions of the type n semiconductor (101) are electron transport layers.

7. The thermoelectric device according to any one of the previous claims, wherein the type n semiconductor (101) and/or the type p semiconductor (200) are made of calcohalides, antiperovskites, kesterites and/or combinations thereof.

8. The thermoelectric device according to any one of claims 1 to 6, wherein the type n semiconductor (101) is made of SbSel and/or BiSel.

9. The thermoelectric device according to any one of the previous claims, wherein the first and second conductive layers (201, 202) are made of a highly n-doped semiconductor, a low work function material or a dipolar material.

10. The thermoelectric device according to claim 9, wherein the highly n-doped semiconductor is selected from doped silicon, doped gallium arsenide, organic n-type semiconductors and/or combinations thereof, the low work function material is selected from alkali metals, alkaline earth metals, lithium fluoride, silver oxide, zinc oxide, tin oxide, titanium oxide, carbon nanomaterials, rare earth metals and/or combinations thereof, and the dipolar material is selected from lithium fluoride, magnesium oxide, polymers comprising amino groups and/or combinations thereof.

11. The thermoelectric device according to anyone claims 1 to 6 and 8 to 10, wherein the type p semiconductor (102) is made of Sb₂Se₃, Cu₂ZnSnS₄ and/or Cu₂ZnSnSe₄.

12. The thermoelectric device according to any one of the previous claims, wherein the third and fourth conductive layers (203, 204) are made of a highly p-doped semiconductor, a high work function material or a dipolar material.

13. The thermoelectric device according to claim 12, wherein the highly p-doped semiconductor is selected from copper oxide, antimony tin dioxide and/or combinations thereof, the high work function material is selected from noble metals, molybdenum trioxide, vanadium oxide, tungsten oxide, PEDOT-PSS and/or combinations thereof, and the dipolar material is selected from carbazoles, polymers comprising sulfonate groups, polymers comprising amino groups such as poly(amidoamine), polyethyleneimine, ethoxylated polyethyleneimine and/or combinations thereof.

14. The thermoelectric device according to any one of the previous claims, wherein the conductive layers (201, 202, 203, 204) are made of a dipolar material.
